(19) Europäisches Patentamt
European Patent Office
Office européen des brevets

(11) **EP 4 246 174 A1**

(12) **EUROPEAN PATENT APPLICATION**

(43) Date of publication:
**20.09.2023 Bulletin 2023/38**

(21) Application number: **22162252.5**

(22) Date of filing: **15.03.2022**

(51) International Patent Classification (IPC):
**G01S 7/40** *(2006.01)*    **G01S 7/03** *(2006.01)*
**H01Q 1/42** *(2006.01)*    G01S 13/931 *(2020.01)*
G01S 13/02 *(2006.01)*    G01S 13/42 *(2006.01)*

(52) Cooperative Patent Classification (CPC):
**G01S 7/4017; G01S 7/03;** G01S 13/426;
G01S 13/931; G01S 13/933; G01S 13/937;
G01S 2013/0245

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Rockwell Collins, Inc.**
**Cedar Rapids, IA 52498 (US)**

(72) Inventors:
- **MANICA, Luca**
  **38062 Arco (IT)**
- **TIANA, Carlo**
  **Goldendale, 98620 (US)**

(74) Representative: **Dehns**
**St. Bride's House**
**10 Salisbury Square**
**London EC4Y 8JD (GB)**

(54) **ANTENNA ARRAY FAILURE DETECTION**

(57)    A system for monitoring the functioning of a plurality of radiating elements in an antenna array of a radar, the radiating elements (1) being positioned beneath a radome (6); the system comprising a plurality of probes (7) arranged to be embedded in or attached to a surface of the radome to measure parameters of a field radiated from the array of radiating elements, means for acquiring (100) the measured parameters from the probes and for processing (102) the measured parameters to identify faulty operation of one or more of the radiating elements based on the measured parameters and to identify the one or more radiating elements identified as having faulty operation.

FIG. 2

EP 4 246 174 A1

**Description**

TECHNICAL FIELD

The present disclosure is concerned with monitoring the health of an antenna array, for example an antenna array for radar purposes installed on an aircraft, and repairing partially inoperable antenna systems.

BACKGROUND

Radars use radio frequency (RF) spectrum energy to detect objects or targets and find use in many fields including in ships, road vehicles and aircraft. Simply stated, a radar system includes a transmitter that transmits modulated or pulsed signals in the RF range. If the transmitted signal meets an object, it is reflected by the object and detected by a receiver. Based on characteristics of the received signal, the range, size, speed, direction of movement etc. of the object can be determined. In automotive or avionics applications, such radar technology can be used to warn an operator, or to control an automatically operated vehicle/aircraft based on detection of obstacle, scene or the like. Radars are also used on aircraft to control the landing of the aircraft based on radar detection of the landing area.

Different radar technologies are known including pulsed, continuous wave (CW) and Frequency Modulated Continuous wave (FMCW) radars. A radar typically includes an array of radiating elements which emit radiation with a particular strength and direction and, e.g. if modulated or encoded, with a particular frequency and/or phase. Antenna arrays can be mechanically steered or electronically steered. A so-called phased array antenna allows the radiated waved to be steered by adjusting a phase difference between the signals emitted from different radiating or antenna elements in the array. Mechanical steering involves physically changing the position or orientation of the antenna elements. Many types of radar device are known in the art and the radar functioning will not be described further here.

In front of a radar antenna system is typically installed a radome which is a structural housing that protects the antenna elements from the environment and against impact or weather damage, but without having any substantial attenuating effect on the radar signals.

Although the radar parts are generally protected, there is still a risk of faults arising within the system resulting in unreliable and potentially dangerous operation or failure to function. It is important to be able to monitor the systems for such failures.

Similarly, when building/installing/providing radar systems using parts supplied by a third party, it is important to be able to check that the components are functioning properly. This is particularly the case for aircraft radars, where very stringent safety criteria have to be met. Engineers designing radars for aircraft are required to build the systems so as to ensure the necessary design assurances are provided but the safety and reliability of parts of the system provided by third parties are not under the control of the engineers.

There is, therefore, a need to be able to check the correct functioning of a radar during design and also during use.

Health monitoring systems currently used for radars focus on monitoring the health of the control points - i.e. the amplifiers and phase shifters that control the radiation. Such monitoring, however, does not recognise any failure of the radiating elements themselves, or failure in the circuit board between the control points and the radiating elements. In the case of failure of/damage to the radiating elements, the radar system can lose performance without the monitoring system identifying or reporting any failure. Control systems or personal e.g. the pilot can then be provided with false information during aircraft operations and not be aware that the radar is not functioning reliably.

There is, therefore, a need for a reliable way of monitoring the health of the radiating elements of a radar system. It would also be desirable if any failures detected could be reported and/or compensated.

SUMMARY

According to the disclosure, there is provided a system for monitoring the functioning of a plurality of radiating elements in an antenna array of a radar, the radiating elements being positioned beneath a radome; the system comprising a plurality of probes arranged to be embedded in or attached to a surface of the radome to measure parameters of a field radiated from the array of radiating elements, means for acquiring the measured parameters from the probes and for processing the measured parameters to identify faulty operation of one or more of the radiating elements based on the measured parameters and to identify the one or more radiating elements identified as having faulty operation.

If defective elements are identified, the system can report these and/or perform a compensation operation such that the remaining healthy radiating elements are adjusted to compensate for the loss of the faulty elements.

BRIEF DESCRIPTION

Examples of the system and method according to the disclosure will be described by way of example only with reference to the drawings. It should be noted that these are examples only and variations are possible within the scope of the claims.

Figure 1A is a schematic of a conventional electronically steered phased antenna array.

Figure 1B is a schematic of a conventional mechanically steered antenna array.

Figure 2 is a schematic showing an example of a system according to the disclosure used with an antenna array such as shown in Fig. 1A.

DETAILED DESCRIPTION

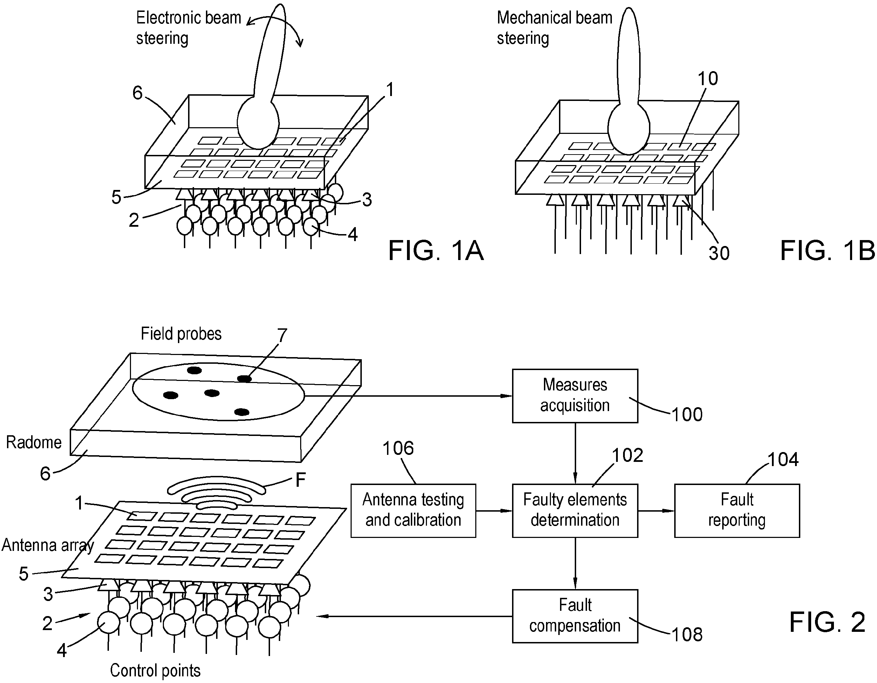

The conventional antenna arrays of Figs. 1A and 1B will be very briefly described by way of background. These are, however, conventional and known in the art and these and other types of antenna array, with which the system and method of this disclosure may be used, will be well known to those skilled in the art without further description.

Figure 1A shows a typical phased antenna array comprising an array of radiating elements 1 each of which has a control point 2 comprising an amplifier 3 and a phase shifter 4 to steer the radiation from each respective element 1. Circuitry between the control points 2 and the radiating elements 1 is provided on a circuit board 5. The circuitry and the radiating elements are mounted in a protective radome 6 which is typically made of a clear plastic so as not to have any substantial attenuating effect of the radiation signals transmitted from or received by the radar. In the example of Fig. 1A, the radiation is steered electronically, as described above, by means of the phase shifters 4 varying the phases of the signals from the respective elements.

Figure 1B also shows an array of radiating antenna elements 10 each having an associated signal amplifier 30. The radiation from the array is steered mechanically by physically moving the radiating elements 10.

Without going into too much detail about the radar operation of such antenna arrays, the electric field that is emitted from the array will be made up of an element factor for each radiating element of the array and an array factor for the effect of all elements working together in an array.

The electric field radiated by the array can be expressed as:

$$F(\theta, \phi) = EF(\theta, \phi) \cdot AF(\theta, \phi) \qquad (1)$$

being, $EF(\theta, \phi)$ the element factor, i.e., the field radiated by the elements composing the array and $AF(\theta, \phi)$ computed as:

$$AF(\theta, \phi) = \sum_{n=1}^{N} w_n \exp[j(\mathbf{k} \cdot \mathbf{r_n})] \qquad (2)$$

Where in equation (2), $\mathbf{k} = 2\pi/\lambda[\sin\theta\cos\phi, \sin\theta\sin\phi, \cos\theta]$ is the wave vector being $\lambda$ the wave-length at the working frequency of the array, $\mathbf{r_n} = (x_n, y_n, z_n)$; $n = 1, ....N$ are the array element positions and $w_n = \alpha_n \exp(j\beta_n)$; $n = 1, ...,N$ are the antenna element weights being $\alpha_n$ and $\beta_n$ the amplitude and phase weight for the $n^{th}$ element. Mechanical and electronic steering lead to different weight's typologies as:

$$w_n = \begin{cases} \alpha_n; & n = 1, ..., N - mechanical\ steering \\ \alpha_n \exp(j\varphi_n); & n = 1, ..., N - electrical\ steering \end{cases} \qquad (3)$$

These are just two simple examples of antenna arrays with which the system and method of the present disclosure can be used.

As mentioned above, the present disclosure is concerned with monitoring the health of the array elements. Whilst the solution of the present disclosure can be used with any type of radar including those discussed above and shown in Figs 1A and 1B, it will be described further, by way of example only, with reference to Fig. 2 which shows the health monitoring solution in the context of a phased array such as shown in Fig. 1A. For the parts of the system that are common to Fig. 1A, the same reference numerals will be used. The radar is shown in Fig. 2 in a partially exploded view.

To monitor the health or operation of the radiating elements 1, according to the disclosure, a plurality of probes 7 is embedded into the radome 6, or is mounted at an internal or external interface of the radome with the circuitry, in the proximity of the radiating elements 1, to detect the electrical field $F(\theta, \phi)$ radiated by the radiating elements 1 or some other parameter of a signal from the radiating elements during beam scanning. The values measured by the probes 7, here indicated by measurement acquisition' 100, are then processed at post-processing stage 102, to identify faults in one or more of the radiating elements 1. Examples of ways in which the measured values can be processed will be discussed further below, but important to the disclosure is that the probes are embedded in the radome or mounted on the radome, and measure a signal from the radiating elements and this measurement is processed to obtain information about the functioning of the radiating elements in the array. The data may be processed based on data used for antenna testing and calibration (stage 106) whereby the measured values are compared with expected values for normal functioning, perhaps with some calibration or processing to take into account that the probes are measuring near-field values, as discussed further below.

The probes 7 are in the form of low-profile (substantially flat) antennas e.g. antenna patches which may have different shapes and sizes according to design and application.

The information obtained from the processing of the measurements from the probes may be used in various ways. For example, the information may be sent to a fault reporting means, at the fault detection stage 104 to provide an indication that a fault has been detected and, in some cases, what that fault is/ which radiating element(s) has/have a fault. The fault reporting means may provide a notification of the fault e.g. a visual and/or audible indication. In an example, the fault detection may be reported in the cockpit of the aircraft to alert the pilot or crew. Alternatively, if the system is used during design or testing of the system, the fault may be reported to a design engineer and/or to a computer.

In addition to, or instead of, using the information from the processing of the probe signal for reporting faults, the information may also be used to provide compensation for the fault (stage 108). For example, the information about the fault may be provided to a control system for controlling the beam forming for the array, such that the remaining healthy radiating elements can be controlled to provide an adjusted output that takes into account and compensates for the faulty element(s). This may involve, for example, increasing the power of and/or modifying the phase of the healthy elements. An algorithm can be used to control the beam forming of the array based on the probe signals.

The probes 7 may be arranged to measure any useful characteristics of the radiating elements that allow a determination to be made as to whether the radiating elements are functioning properly, for example power or field, which can be compared with the values that would normally be expected if the array elements are functioning correctly. The measurements and processing may be made in real time operation of the radar and/or may be made in an off-line testing procedure to ensure that the radar system is functioning correctly before supply, installation etc.

The number of probes 7 used will depend of various factors and on the application in question. Particularly where it is desirable to reduce the number of parts and wires, an array of probes may be designed and located in the probe such that each probe detects signals from several radiating elements and based on signal strength and direction, a determination can be made, at the processing stage 102, which radiating element(s) contributing to the signal received by any probe is/are faulty. There is an advantage in aircraft where weight is to be minimized and where a large number of wires, even when thin wires are used, is to be avoided to minimise interference, to designing the array of probes to have as few probes as possible, and this also minimises the overall cost of the system. In one example, the minimum number of probes is K*log(N), where K is the maximal number of faulty elements and N is the number of antenna array elements. K is typically in the order of 1 % of N. To determine the smallest number of probes possible to obtain reliable health monitoring of an array of radiating elements, the number or probes and their locations necessary to reconstruct the field of the radiating elements can be computed. The design works on the assumption that the number of failed elements will be small with respect to the overall number of elements in the array.

Each probe 7 may be connected to the rest of the monitoring system by a separate wire/microstrip line (not shown). Alternatively, the wires from the individual probes can be combined.

By being embedded in, or mounted on the radome 6 adjacent the radiating elements, the probes will be sensing near-field data from the elements 1. The radar system, however, works using far-field data. This means that the expected data/measurement that may be used in the processing stage may be a far-field measurement value. Whilst in some cases, the near-field measurement can be used directly, if the diagnostic system knows what near-field values would be expected, if only the far-field values of a properly functioning system are known, then a near-field to far-field transformation process can be performed on the measurement values obtained by the probes before this data is processed to identify faults.

To identify the positions of faulty elements based on a fewer number of probes than elements, a compressed sensing approach may be used. Such techniques are discussed in e.g. D.L.Donoho, '"Compressed sensing", IEEE Trans. Inf. Theory, vol. 52, no. 4, pp. 1289 - 1306, April 2006 and in M.D. Migliore, 'A compressed sensing approach for array diagnosis from a small set of near-field measurements", IEEE Trans. Antennas Propag., vol. 59, no. 6, pp. 2127-2133, June 2011. The processing can, for example, take into account the distance between the probe and the array element and the relative angles between the probe and the array element as well as the field collected by the probe.

The radome will have some effect on the measured values and preferably this is compensated for in the processing; the effect of the radome will be different depending on whether the probes are embedded in the radome, are on the interior of the radome interface side or on the exterior thereof. Calculation methods are known using propagation in stratified lossy media and using a transfer matrix method, taking into account how the signals travel in the radome media and the presence of any interface between media.

In general, it is desirable to minimize the number of probes. Therefore, a sparse network of probes may be laid out that is designed to minimally perceive the radiation pattern from all elements of the antenna when that radiation pattern is just above the probe network's detection threshold. Thus it is not necessary to place a probe near each radiating element, but rather only enough probes are necessary to capture the radiation pattern from all the elements. The radiation pattern may also be tailored specifically for the purposes of determining the health of the system, and need not be a uniform radiation pattern, nor a single radiation pattern. Different subsets of one or more up to all radiating elements may be commanded to radiate a specific pattern at one time, and then immediately in succession another different radiation pattern, in order to optimize the trade-off between the sparsity of the probe network and the accurate determination of antenna health. The probe density and configuration are dependent on the density, configuration and power addressability of the elements of the antenna, as well as the desired accuracy for determination of antenna health. For example, a decision of whether an element is operable or inoperable may be accomplished with a more sparse probe network than would be required for accurate compensation of performance of a poorly performing emitter elements.

The voltage at the probes depends on field radiated by the antenna array. Moreover, it can be expressed as a linear system of equations determined by the antenna array geometry. To identify faults in the antenna array, the linear system must be inverted i.e. it must be solved for the situation where some elements are faulty. This would require the number of probes to be greater than or equal to the number of radiating elements which would require a large number of probes. To reduce the number of probes, the determination may be made using an assumption that the number of faulty elements, compared to the overall number of elements, is small. Then, the following approach can be used:
First, the value of the radiated field for a fault-free array is measured with the probes positioned in their selected locations. This step can be performed during array testing or calibration (stage 106). The measurements are stored as a reference measurement vector. Alternatively, such reference value can be obtained by simulating the antenna system using commercial EM solvers. Next, the radiated field of the actual antenna array is measured using the probes and these measurements form a data measurement vector. If the number of faults is small, the vector defined as the difference between the measurements of a not-faulty and faulty array is sparse, and so the system of equations used to determine the positions of the faulty elements consider a sparse known term.

The processing of the measured values will provide an indication of whether there is a failure in the radiating elements and, if so, which element(s) is/are faulty.

This can, as mentioned above, be reported as a fault with an indication for crew, maintenance staff, an engineer etc. to take appropriate action.

In addition, or alternatively, the information can be used in a compensation algorithm to provide an output to modify the control of the array to take into account that one or more of the elements (and knowing which elements) are faulty and not contributing to/properly contributing to the radar function. For example, for the system of Fig. 2, the amplifier gain and/or the phase of the control elements of the healthy elements can be modified to compensate for the faulty element(s). The beamforming control will be performed, based on knowing which elements are faulty, on the other (nonfaulty) control points by determining the amplitudes and phases for those control points that will create a radiation pattern that satisfies again the operational requirements. This may be expressed in terms of a convex optimization problem subject to non-linear constraints. This will take into account the positions of the functioning elements and their weights in contributing to the pattern and the amplifier gain and phase can be adjusted accordingly. M. D'Urso et al "Solving some array synthesis problems by means of an effective hybrid approach", IEEE Trans. Antennas Propag., vol 55, no. 3, pp. 750-759, March 2007 and T. Iserna et al, "A hybrid approach for the optimal synthesis of pencil beams through antenna arrays", IEEE Trans. Antennas Propag., pp. 2912 - 2918, Nov. 2004 describe methodologies that can be used to solve these problems.

The solution provided by this disclosure provides a system in which an independent system can monitor and establish correct operation of a radar. This allows for an increased assurance level of the overall system which is important especially for safety-critical applications such as for controlling the landing of an aircraft.

If the system provides compensation for the failure, this improves the resilience of the radar system in the event of unexpected failures. The system can detect faults due to component damage or wear and also can compensate or detect system aging or temperature drifting.

## Claims

1. A system for monitoring the functioning of a plurality of radiating elements in an antenna array of a radar, the radiating elements (1) being positioned beneath a radome (6); the system comprising a plurality of probes (7) arranged to be embedded in or attached to a surface of the radome to measure parameters of a field radiated from the array of radiating elements, means for acquiring (100) the measured parameters from the probes and for processing (102) the measured parameters to identify faulty operation of one or more of the radiating elements based on the measured parameters and to identify the one or more radiating elements identified as having faulty operation.

2. The system of claim 1, further comprising means for providing a report (104) of the faulty radiating elements.

3. The system of claim 1 or 2, further comprising means for adjusting (108) operation of radiating elements of the array not identified as faulty to compensate for the faulty radiating elements.

4. The system of any preceding claim, further comprising one or more conductors connecting the probes to the means for acquiring the measured parameters.

5. The system of any preceding claim, wherein the number of probes is a minimum number of probes calculated from K*log(N) where K is a predetermined maximum number of faulty elements and N is the number of radiating elements in the array.

6. The system of any preceding claim, further comprising means for performing a near-field to far-field transformation process on the acquired measurement parameters.

7. The system of any preceding claim, wherein processing (102) the measured parameters to identify faulty operation of one or more of the radiating elements comprises performing a compressed sensing process.

8. The system of claim 7, wherein the compressed sensing process takes into account distances between the probes and the radiating elements, relative angles between the probes and the radiating elements and field values measured by the probes.

9. The system of any preceding claim, wherein the array is an electrically steered array.

10. The system of any of claims 1 to 8, wherein the array is a mechanically steered array.

11. A method of monitoring the functioning of a plurality of radiating elements in an antenna array of a radar, the radiating elements (1) being positioned beneath a radome (6); the method comprising locating a plurality of probes (7) embedded in or attached to a surface of the radome to measure parameters of a field radiated from the array of radiating elements, acquiring (100) the measured parameters from the probes for processing (102) the measured parameters to identify faulty operation of one or more of the radiating elements based on the measured parameters and to identify the one or more radiating elements identified as having faulty operation.

12. The method of claim 11, further comprising providing a report (104) of identified faulty radiating elements.

13. The method of claim 11 or 12, further comprising adjusting (108) operation of radiating elements of the array not identified as faulty to compensate for the faulty radiating elements.

14. The method of claim 13, wherein the adjusting includes performing a beam forming process on the array.

Mechanical beam steering

10

30

**FIG. 1B**

Electronic beam steering

1
3
4
6
5
2

**FIG. 1A**

104

Fault reporting

100

Measures acquisition

102

Faulty elements determination

108

Fault compensation

106

Antenna testing and calibration

Field probes

7

Radome

6

F

Antenna array

1
5
3
2
4

Control points

**FIG. 2**

Europäisches
Patentamt

European
Patent Office

Office européen
des brevets

**EUROPEAN SEARCH REPORT**

Application Number

EP 22 16 2252

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 005 210 A1 (ISRAEL AEROSPACE IND LTD [IL]) 24 December 2008 (2008-12-24) | 1-6,9-14 | INV. G01S7/40 |
| Y | * paragraphs [0009] - [0011], [0036], [0038] - [0053], [0060], [0064] - [0068], [0075] - [0079]; figures 1-3,5-7 * | 7,8 | G01S7/03 H01Q1/42 |
| | ----- | | ADD. G01S13/931 |
| Y | US 9 409 151 B1 (WEST JAMES B [US] ET AL) 9 August 2016 (2016-08-09) * column 3, line 47 - column 4, line 43; claims 1,3; figures 4, 5 * * column 5, paragraph 14 - column 6, paragraph 11; figures 8, 9 * | 1-14 | G01S13/02 G01S13/42 |
| | ----- | | |
| Y | EP 3 392 669 A1 (ROHDE & SCHWARZ [DE]) 24 October 2018 (2018-10-24) * paragraphs [0029] - [0043]; figures 1-4 * | 1-14 | |
| | ----- | | |
| Y | US 4 926 186 A (KELLY ROBERT J [US] ET AL) 15 May 1990 (1990-05-15) * column 1, line 62 - column 2, line 19 * * page 13, lines 28-44; figure 3 * | 1-14 | TECHNICAL FIELDS SEARCHED (IPC) G01S H01Q |
| | ----- | | |
| Y,D | D.L. DONOHO: "Compressed sensing", IEEE TRANSACTIONS ON INFORMATION THEORY, vol. 52, no. 4, 1 April 2006 (2006-04-01), pages 1289-1306, XP055278657, USA ISSN: 0018-9448, DOI: 10.1109/TIT.2006.871582 * the whole document * | 7,8 | |
| | ----- | | |
| | -/-- | | |

The present search report has been drawn up for all claims

| Place of search | Date of completion of the search | Examiner |
|---|---|---|
| Munich | 25 August 2022 | Schmelz, Christian |

EPO FORM 1503 03.82 (P04C01)

Europäisches
Patentamt

European
Patent Office

Office européen
des brevets

# EUROPEAN SEARCH REPORT

Application Number

EP 22 16 2252

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | MIGLIORE MARCO DONALD: "A Compressed Sensing Approach for Array Diagnosis From a Small Set of Near-Field Measurements", IEEE TRANSACTIONS ON ANTENNAS AND PROPAGATION, vol. 59, no. 6, 1 June 2011 (2011-06-01), pages 2127-2133, XP055955031, USA ISSN: 0018-926X, DOI: 10.1109/TAP.2011.2144556 Retrieved from the Internet: URL:https://ieeexplore.ieee.org/stampPDF/g etPDF.jsp?tp=&arnumber=5752825&ref=aHR0cHM 6Ly9pZWVleHBsb3JlLmllZWUub3JnL2Fic3RyYWN0L 2RvY3VtZW50LzU3NTI4MjU=> * the whole document * ----- | 7,8 | |

TECHNICAL FIELDS SEARCHED (IPC)

The present search report has been drawn up for all claims

| Place of search | Date of completion of the search | Examiner |
|---|---|---|
| Munich | 25 August 2022 | Schmelz, Christian |

EPO FORM 1503 03.82 (P04C01)

## ANNEX TO THE EUROPEAN SEARCH REPORT
## ON EUROPEAN PATENT APPLICATION NO.

EP 22 16 2252

25-08-2022

| Patent document cited in search report | | Publication date | Patent family member(s) | | Publication date |
|---|---|---|---|---|---|
| EP 2005210 | A1 | 24-12-2008 | EP | 2005210 A1 | 24-12-2008 |
| | | | IL | 193866 A | 29-12-2011 |
| | | | US | 2009058715 A1 | 05-03-2009 |
| | | | WO | 2007113790 A1 | 11-10-2007 |
| US 9409151 | B1 | 09-08-2016 | NONE | | |
| EP 3392669 | A1 | 24-10-2018 | EP | 3392669 A1 | 24-10-2018 |
| | | | EP | 4009071 A1 | 08-06-2022 |
| | | | JP | 7018280 B2 | 10-02-2022 |
| | | | JP | 2018179961 A | 15-11-2018 |
| | | | US | 2018306903 A1 | 25-10-2018 |
| US 4926186 | A | 15-05-1990 | NONE | | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D.L.DONOHO.** Compressed sensing. *IEEE Trans. Inf. Theory,* April 2006, vol. 52 (4), 1289-1306
- **M.D. MIGLIORE.** A compressed sensing approach for array diagnosis from a small set of near-field measurements. *IEEE Trans. Antennas Propag.,* June 2011, vol. 59 (6), 2127-2133
- **M. D'URSO et al.** Solving some array synthesis problems by means of an effective hybrid approach. *IEEE Trans. Antennas Propag.,* March 2007, vol. 55 (3), 750-759
- **T. ISERNA et al.** A hybrid approach for the optimal synthesis of pencil beams through antenna arrays. *IEEE Trans. Antennas Propag.,* November 2004, 2912-2918